# EUROPEAN PATENT APPLICATION

(11) **EP 1 058 316 A1**
(43) Date of publication of application: **06.12.2000**
(21) Application number: 99830343.2
(22) Date of filing: 04.06.1999
(51) Int. Cl.: H01L 29/739, H01L 29/78, H01L 29/08, H01L 21/331, H01L 21/336

(54) **Power MOS transistor**

(71) Applicant: STMicroelectronics S.r.l., 20041 Agrate Brianza (Milano) (IT)
(72) Inventor: Fragapane, Leonardo, 95121 Catania (IT); Magri', Angelo, 95032 Belpasso (Catania) (IT)
(74) Representative: Maccalli, Marco

(57) **Abstract**

A MOS power device such as a power MOSFET (eg. VDMOS) or an insulated gate bipolar transistor (ie. IGBT) with a high dynamic ruggedness, which comprises a parasitic bipolar transistor having its base in a base region (3,5) of the power device and means for counter-biasing the parasitic bipolar transistor. The counter-biasing means are resistive means inserted between a source region (4) of the power device and an emitter (E1) of the parasitic bipolar transistor (NPN). Said resistive means may consist of a lightly doped region (12) of the same conductivity type as that of the source region (4) of the power device and disposed in the base region (3,5) of the power device, under said source region (4).

## Description

The present invention relates to the field of semiconductor power devices, particularly to the sector of MOS-technology power devices, such as power MOSFETs and insulated gate bipolar transistors (IGBTs for short).

As is known, a power device of the IGBT type, being a four-layer device (NPNP), is intrinsically associated with a parasitic thyristor (or "silicon controlled rectifier", SCR) whose triggering must be prevented.

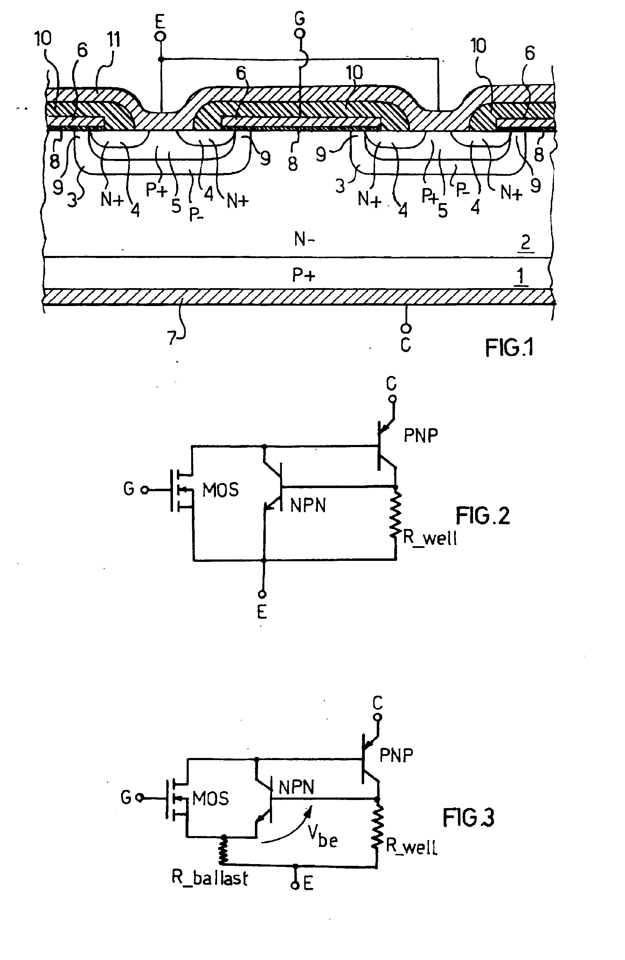

With reference to Figure 1, a portion of a conventional IGBT is shown in cross-section, an equivalent electrical circuit of this device being shown in Figure 2. The IGBT comprises a highly doped semiconductor substrate 1 having a first type of conductivity, for example P+; a metal layer 7, forming the collector C of the IGBT, is applied to the back of the substrate 1. A lightly doped semiconductor layer 2 having a second type of conductivity, N in the example, is formed by epitaxy on the substrate 1. A plurality of P-type base regions 3, constituting elementary functional units of the IGBT, is formed in the layer 2. Heavily doped N-type regions 4, constituting source regions 4 of the IGBT, are formed in the base regions 3 whose doping is moderate and is determined by the threshold voltage value desired for the IGBT. Heavily doped P+ regions 5 are also formed in the base regions 3, under the source regions 4.

A gate electrode 6, typically made from doped polysilicon and insulated from the underlying silicon by means of a gate oxide layer 8, is provided on the surface of the layer 2. The gate electrode 6 extends between adjacent base regions 3 and partially over the base regions 3 to the source regions 4. The portions of the base regions 3 lying under the gate electrode 6 form channel regions 9 of the IGBT.

A layer of insulating material 10 covers the gate electrode 6, and a metal layer 11 contacts the source regions 4 and the central part of the P+ regions 5, thus short-circuiting them. The layer 11 forms the emitter electrode E of the IGBT. A gate electrode G is also provided; this contacts the polysilicon layer 6 in an area of the chip which is not shown.

As shown by the equivalent circuit diagram in Figure 2, the IGBT is comparable to a power MOSFET (MOS in Figure 2), in parallel with a parasitic NPN bipolar transistor which, together with a parasitic PNP bipolar transistor, forms a thyristor. The resistance R_well is the resistance of the portion of P+ region 5 which extends from the contact with the metal layer 11 under the source regions 4 to the limit of these regions.

The characteristics of dynamic ruggedness of these devices on turning off ("turn-off latching") and switching in short-circuit conditions are affected to a considerable degree by the resistance R_well.

This is because some of the holes that are injected from the back of the device pass through the resistance R_well and thus cause a voltage drop in the portion of the base region under the source; this voltage drop can cause the forward biasing of the base-emitter junction of the parasitic NPN bipolar transistor, and consequently turn this transistor on.

The most common solutions to this problem consist in decreasing the flow of injected holes by introducing a "life-time killer" into the epitaxial layer 2 of the device, or increasing the concentration of dopant in the portion of the base region under the emitter, so that the resistance R_well is decreased.

A third known solution, generally used in combination with the two previous ones, consists in forming so-called "ballast" resistances. The equivalent circuit diagram of this solution is shown in Figure 3. A current consisting of the sum of the electron currents of the power MOSFET and of the parasitic NPN bipolar transistor flows through the ballast resistance R_ballast connected in series with the source of the power MOSFET and the emitter of the parasitic NPN bipolar transistor, and this current causes a rise in the emitter voltage of the said NPN transistor and of the source of the power MOSFET.

Thus a negative emitter feedback is introduced; the base-emitter voltage (Vbe) of the parasitic NPN bipolar transistor is lower than in the preceding case, being determined by the voltage across the resistance R_well from which the voltage drop across the resistance R_ballast is subtracted. The parasitic NPN bipolar transistor is therefore turned on by a higher value of current flowing in the parasitic PNP bipolar transistor.

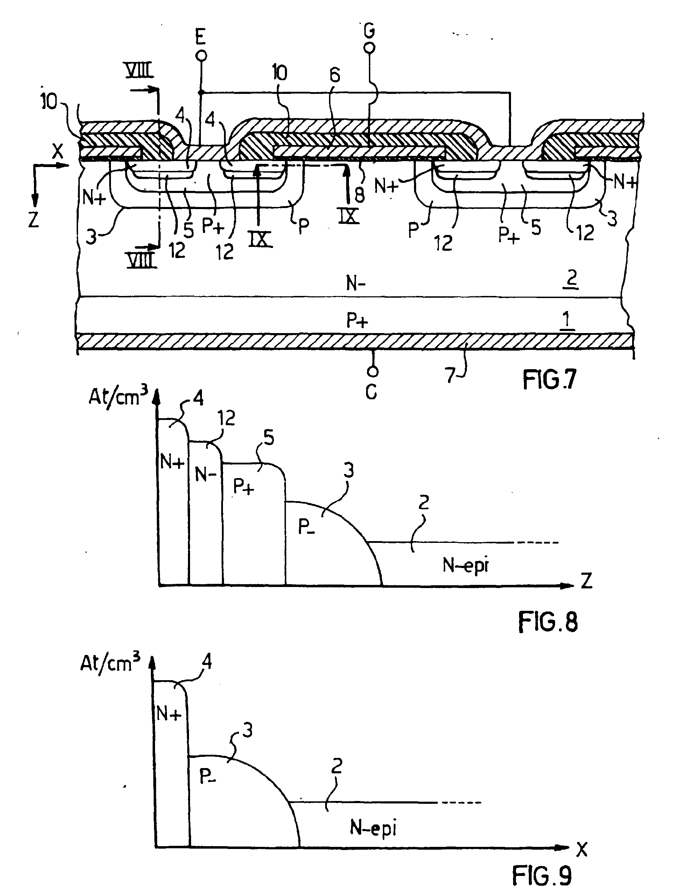

Figures 4 and 5 show a possible way of producing the ballast resistance R_ballast, in an IGBT having a stripe structure. As shown in Figure 5, a section of which along the line IV-IV is shown in Figure 4, the base regions 3 are elongated stripes, and within these the emitter regions 4 are substantially continuous, with a longitudinal succession of apertures where the P+ regions 5 remain exposed. Under these apertures, therefore, the source regions 4 are not contacted by the metal coating layer 11, and the currents I_mos (current of the power MOSFET MOS) and I_npn (current of the parasitic NPN bipolar transistor) must flow through a longer path to reach the emitter electrode E. This longer path gives rise to the resistance R_ballast.

However, the presence of the ballast resistance has a detrimental effect on the saturation voltage (Vcesat) of the IGBT. This is because the ballast resistance increases not only the emitter voltage of the parasitic NPN bipolar transistor, but also the source voltage of the power MOSFET, thus decreasing the overall gate-source voltage (Vgs) of the device. The decrease of the voltage Vgs causes a decrease of the drain current of the power MOSFET, and since this current forms the base current of the parasitic PNP bipolar transistor, the output current of the PNP transistor, and consequently of the IGBT, is reduced.

A problem of ruggedness similar to that shown by IGBTs, although less evident, is also inherent in power MOSFETs whose cross-section is identical to that of the IGBT shown in the figure, but without the P+ layer 1. A device of this type is intrinsically associated with a parasitic bipolar transistor, more precisely the NPN transistor in Figures 2 and 3, with its collector and emitter consisting, respectively, of the drain and source of the power MOSFET, and with its resistance R_well in series with the base. The turning on of the parasitic NPN bipolar transistor as a result of the voltage drop across the resistance R_well creates a concentration of current which may destroy the power MOSFET. In this case also, the insertion of the ballast resistance in a similar way to that shown in Figure 3 has the result of increasing the saturation voltage of the power MOSFET.

In view of the prior art described above, an object of the present invention was to provide a MOS-technology power device which has a high dynamic ruggedness, without the negative effect of this on the saturation voltage which is found in the known solutions.

According to the present invention, this object is achieved by means of a MOS-technology power device, which is intrinsically associated with a parasitic bipolar transistor having its base in a base region of the power device of the MOS type, and comprising counter-biasing means for counter-biasing the parasitic bipolar transistor, characterized in that the said counter-biasing means are inserted between an emitter of the parasitic bipolar transistor and a source region of the MOS-technology power device.

The features and advantages of the present invention will be made clearer by the following detailed description of one of its possible embodiments, illustrated purely by way of a non-limiting example in the attached drawings, in which:
Figure 1 shows a cross-section of an IGBT according to the prior art;
Figure 2 is an equivalent electrical circuit of the IGBT in Figure 1;
Figure 3 shows an equivalent electrical circuit of an IGBT according to the prior art, with a ballast resistance;
Figure 4 is a cross-section of the IGBT in Figure 3;
Figure 5 is a plan view of a portion of the IGBT in Figure 4;
Figure 6 is an equivalent electrical circuit of an IGBT according to the present invention;
Figure 7 is a sectional view, similar to that in Figures 1 and 4, of a portion of an IGBT according to the invention;
Figure 8 shows a doping profile of the IGBT in Figure 7 along the line VIII-VIII in this figure;
Figure 9 shows a doping profile of the IGBT in Figure 7 along the line IX-IX in this figure; and
Figure 10 is an equivalent electrical circuit of a power MOSFET according to the present invention.

With reference to Figure 6, in which parts which are the same as those of the figures discussed previously are identified by the same references, in an embodiment of the present invention a feedback resistance R_npn is connected in series between the emitter of the parasitic NPN bipolar transistor and the source of the power MOSFET, which is directly connected to the emitter electrode E of the IGBT. Unlike the resistance R_ballast in Figure 3, the resistance R_npn acts as a ballast resistance only in respect of the parasitic NPN bipolar transistor, which undergoes a counter-biasing of its emitter E1, thus balancing the voltage drop across the resistance R_well and increasing the current in the parasitic PNP bipolar transistor so that the SCR is turned on. The beneficial effect of the counter-biasing of the NPN transistor does not affect the power MOSFET MOS, whose source 4 is kept at the potential of the emitter E of the IGBT, which is driven by a Vgs voltage equal to the total gate-emitter voltage of the IGBT. Consequently there is no increase in the saturation voltage Vcesat.

A possible practical embodiment of the invention is shown in Figures 7 to 9. With reference to these, the introduction of the ballast resistance R_npn in series with the emitter of the parasitic NPN bipolar transistor is achieved by providing more lightly doped N-type regions 12 under the N+ source regions 4 of the power MOSFET. By way of example, the dopant concentration values in the various regions are approximately 5 x 10²⁰ atoms/cm³ for the N+ region 4, approximately 2 x 10¹⁹ atoms/cm³ for the N- region 12, approximately 1 x 10¹⁹ atoms/cm³ for the P+ region 5, and approximately 1 x 10¹⁸ atoms/cm³ for the P- region 3. The presence of the N-regions 12 does not affect the power MOSFET, as may be seen in Figure 9, while it introduces a resistance in series with the emitter of the parasitic NPN transistor. With reference to Figure 8, the current flowing in the parasitic NPN transistor, before reaching the N+ region 4, encounters the N- region 12 which has a higher resistivity; the N- region 12, which forms the emitter of the parasitic NPN bipolar transistor, on the one hand introduces a distributed resistance between the emitter of the parasitic NPN transistor and the source of the power MOSFET (N+ region 4), and on the other reduces the emitter efficiency of the parasitic NPN bipolar transistor, thus reducing gain thereof.

In this way the latching current of the IGBT is increased both as a result of the counter-biasing of the emitter of the parasitic NPN bipolar transistor and as a result of the reduction of its gain. Consequently the loop gain of the parasitic SCR decreases, and the latching current of the IGBT increases, providing a higher dynamic stability.

All of this is achieved without negative effects on the power MOSFET, since in this case the flow of current is horizontal and does not affect the N- regions 12 (Figure 9); the output current of the power MOSFET, in other words the collector current of the IGBT, remains unchanged, and therefore Vcesat does not increase.

In terms of the manufacturing process, the forming of the N- regions 12 under the N+ regions 4 is carried out, for example, by an implantation at a lower dose but with a higher energy than those of the implantation used to form the N+ regions 4, although the same photolithographic mask is used.

Clearly, the present invention can be applied to IGBTs having either a cellular structure or a stripe structure. The conductivity types of the various semiconductor regions shown and described may also be reversed.

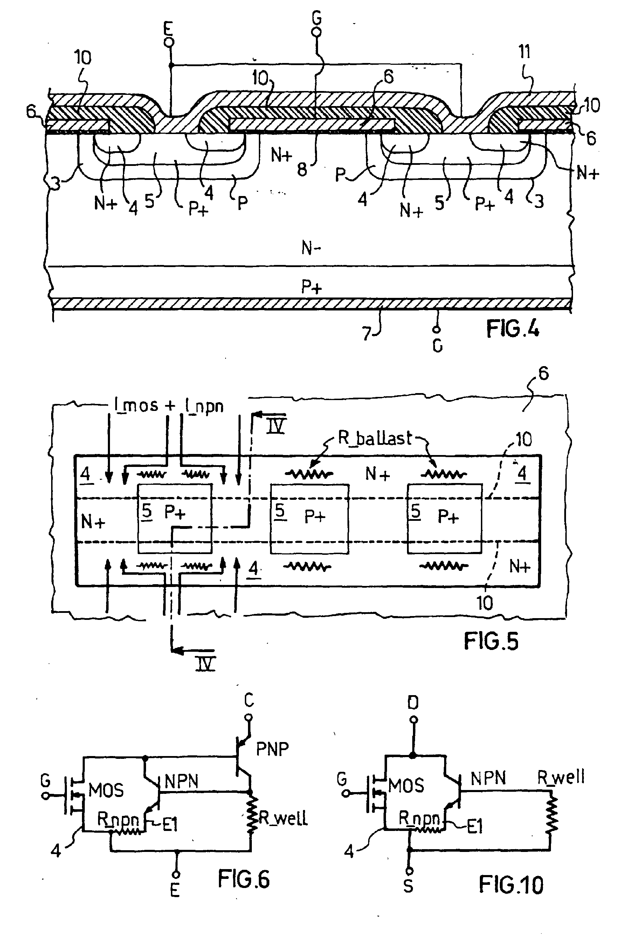

Additionally, the present invention can also be applied directly to power MOSFETs, as shown in Figure 10, where D and S indicate the drain and source electrodes, respectively, of the device. The sectional view is identical to that in Figure 7, except that the P+ substrate 1 is omitted. Exactly as in the case of the IGBT, the presence of the resistance R_npn causes a counter-biasing of the parasitic NPN bipolar transistor intrinsically associated with the power MOSFET, making it more difficult to turn on, but without adversely affecting the performance of the power MOSFET.

From the above description, a person with average skill in the art will easily be able to identify other practical embodiments of the present invention, without departing from the scope of protection defined by the following claims.

## Claims

1. MOS-technology power device which is intrinsically associated with a parasitic bipolar transistor having its base in a base region (3, 5) of the MOS-technology power device, and comprising counter-biasing means for counter-biasing the parasitic bipolar transistor, characterized in that the said counter-biasing means (R_npn) are inserted between an emitter (E1) of the parasitic bipolar transistor (NPN) and a source region of the power device of the MOS type.

2. Power device of the MOS type according to Claim 1, characterized in that the said counter-biasing means (R_npn) are resistive means.

3. Power device of the MOS type according to Claim 2, comprising at least one base region (3, 5) having a first type of conductivity, formed in a semiconductor layer (2) having a second type of conductivity, and at least one highly doped source region (4) of the second type of conductivity formed in the said at least one base region, characterized in that a weakly doped region (12) having the second type of conductivity, which constitutes the said resistive means (R_npn), is formed in the said base region, under the source region.

4. Power device of the MOS type according to any one of the preceding claims, characterized in that it is a power MOSFET.

5. Power device of the MOS type according to any one of Claims 1 to 4, characterized in that it is an insulated gate bipolar transistor (IGBT).

6. Method for manufacturing a MOS-technology power device, characterized in that it comprises the formation of a weakly doped region (12), having a second type of conductivity, within a base region (3, 5) having a first type of conductivity, and under a highly doped source region (4), having the second type of conductivity, of the MOS-technology power device.

7. Method according to Claim 6, characterized in that the said weakly doped region (12), is formed by an implantation of dopant having the second type of conductivity, in a lower dose but at a higher energy than those used for the formation of the said source region (4) of the power device of the MOS type.
